# NEUE EUROPÄISCHE PATENTSCHRIFT

(11) **EP 3 758 214 B2**
(45) Veröffentlichungstag und Bekanntmachung des Hinweises auf die Entscheidung über den Einspruch: **16.07.2025**
(45) Hinweis auf die Patenterteilung: 21.09.2022
(21) Anmeldenummer: 19182235.2
(22) Anmeldetag: 25.06.2019
(51) Int. Cl.: H02P 1/04, H02P 1/28

(54) **MOTORSTARTER UND VERFAHREN ZUM STARTEN EINES ELEKTROMOTORS**
MOTOR STARTER AND METHOD FOR STARTING AN ELECTRIC MOTOR
DÉMARREUR DE MOTEUR ET PROCÉDÉ DE DÉMARRAGE D'UN MOTEUR ÉLECTRIQUE

(43) Veröffentlichungstag der Anmeldung: 30.12.2020
(73) Patentinhaber: Siemens Aktiengesellschaft, 80333 München (DE)
(72) Erfinder: Böke, Willi, 91207 Lauf (DE)
(74) Vertreter: Siemens Patent Attorneys

(56) Entgegenhaltungen:
- EP-A1- 2 192 685
- DE-U1- 9 204 107
- US-B1- 6 420 848
- SIEMENS: „Soft starters SIRIUS 3RW30 /3RW40 - Manual 1/2010“,https://web.archive.org/web/20130607131154/http://www.inverterdrive.c om/file/Siemens-Sirius-3RW30-3RW40-Manual

## Beschreibung

Die Erfindung betrifft einen Motorstarter und ein Verfahren zum Starten eines Motors, nämlich ein Verfahren zum Starten eines Elektromotors. Motorstarter für Elektromotoren und Verfahren zum Starten von Elektromotoren sind an sich bekannt.

Bezüglich des Begriffs Motorstarter muss zwischen zwei Ausführungsformen unterschieden werden: Eine Form eines Motorstarters ist als sogenannter Sanftstarter bekannt. Eine andere Form ist als sogenannter Hybrid Motorstarter bekannt.

Sanftstarter sind während des gesamten Betriebs eines Elektromotors aktiv und reduzieren während des Einschaltvorgangs die Effektivwerte des speisenden Stroms und der speisenden Spannung mittels Phasenanschnitt. Beim Einschalten des Motors ist der maximale Phasenanschnitt wirksam. Beim Anlaufen des Motors wird der Phasenanschnitt nach und nach bis zur vollen Netzspannung reduziert. Nach dem Hochlauf des Motors ist kein Phasenanschnitt mehr wirksam und der Motor wird mit dem Nennstrom betrieben.

Hybrid Motorstarter umfassen eine Kombination von zwei Schalttechnologien (elektronisch mittels Halbleiter, insbesondere Thyristoren oder Triacs, und elektromechanisch durch Kontakt) und sind während des gesamten Betriebs eines Elektromotors aktiv, aber schalten den Motor an das Netz, ohne die Spannung zu reduzieren (also ohne einen Phasenanschnitt).

Darüber hinaus sind Motorschutzschalter, Motorschutzrelais und eine Stern-Dreieck-Schaltung an sich bekannt. Motorschutzschalter, Motorschutzrelais oder eine Stern-Dreieck-Anlaufschaltung umfassen oder sind Schutzschaltungen, die auf zu hohe Ströme beim Einschalten eines Elektromotors ansprechen bzw. einen Anlauf des Elektromotors mit reduzierter Leistungsaufnahme gewährleisten sollen.

Beim Einschalten von modernen Motoren, insbesondere Drehstrom-Asynchronmaschinen mit Energie-Effizienzklassen IE3 oder IE4, durch Motorstarter, zum Beispiel einen Motorstarter mit einem Motorschutzschalter oder ein Schütz mit einem zusätzlichen Motorschutzschalter, entsteht ein sehr hoher Einschaltstrom (Einschaltrush), welcher entsprechende Schutzfunktionen im Motorabzweig auslösen kann. Zum Beispiel kann bei einem Motorschutzschalter durch einen hohen Einschaltstrom ein Überlastschutz des Motors oder ein Kurzsschlussschutz aktiviert werden und bei einem Leistungsschalter durch einen hohen Einschaltstrom der Kurzschlussschutz-Mechanismus ausgelöst werden.

In der Vergangenheit sind solche Effekte eher selten vorgekommen. Aufgrund des vermehrten Einsatzes moderner energieeffizienter Motoren ist davon auszugehen, dass solche Fehler zunehmen werden.

Eine Begrenzung eines Einschaltstroms beim Einschalten eines Elektromotors ist an sich bekannt. Bei Drehstromasynchronmotoren kann der Einschaltstrom wirksam mittels eines sogenannten Sanftstarters begrenzt werden. Hier wird mit einem Phasenanschnitt mittels Thyristoren im Hauptstromkreis die effektive Spannung an den Motorklemmen reduziert und somit auch der Einschalt- und Anlaufstrom begrenzt. Sanftstarter werden für Motoren ab einer Leistung von ca. 5,5 kW durch die Energieversorger bereits zum Schutz der Stromnetze vor Spannungseinbrüchen gefordert und zu diesem Zweck erfolgreich eingesetzt. Für den Einsatz bei kleineren Motoren mit einer Leistung unterhalb von 5,5 kW ist ein Sanftstarter nicht gefordert und lediglich zur Begrenzung des Einschaltstroms auch nicht wirtschaftlich. Der Einsatz erfolgt nur, wenn zusätzlich ein sanfter Start des kompletten Antriebs im Vordergrund steht.

Eine Aufgabe der hier vorgeschlagenen Neuerung besteht darin, einen Motorstarter anzugeben, der kompakt und preiswert ist und sich zum Beispiel auch für eine Verwendung bei Elektromotoren mit einer Leistung von weniger als ca. 5,5 kW eignet. Eine weitere Aufgabe besteht darin, ein Verfahren zum Betrieb eines solchen Motorstarters anzugeben.

Diese Aufgabe wird erfindungsgemäß mittels eines Motorstarters sowie eines Verfahrens zum Starten eines Elektromotors mit den Merkmalen der jeweiligen unabhängigen Ansprüche gelöst. Dazu ist bei einem zum Starten eines Elektromotors bestimmten Motorstarter Folgendes vorgesehen: Der Motorstarter umfasst eine Phasenanschnittseinheit, insbesondere eine grundsätzlich an sich bekannte Phasenanschnittseinheit, und eine Steuerungseinheit. Mittels der Steuerungseinheit ist die Phasenanschnittseinheit nach Ablauf einer vorgegebenen oder vorgebbaren Wirksamkeitsdauer der Phasenanschnittseinheit deaktivierbar. Die Steuerungseinheit ist also dafür bestimmt und eingerichtet, die Phasenanschnittseinheit nach Ablauf der vorgegebenen oder vorgebbaren Wirksamkeitsdauer zu deaktivieren. Bei einem korrespondierenden Verfahren zum Betrieb eines solchen Motorstarters deaktiviert die Steuerungseinheit die Phasenanschnittseinheit nach Ablauf der vorgegebenen oder vorgebbaren Wirksamkeitsdauer der Phasenanschnittseinheit.

Die der Erfindung zugrunde liegende Aufgabe wird außerdem gelöst mittels eines Systems mit zumindest einer mittels eines Elektromotors antreibbaren Transporteinrichtung, wobei der Elektromotor mittels eines erfindungsgemäßen Motorstarters einschaltbar ist und/oder mittels eines erfindungsgemäßen Verfahrens eingeschaltet wird.

Weil nach dem hier vorgeschlagenen Ansatz der Phasenanschnitt - anders als bei einem Sanftstarter - nur für begrenzte Zeit wirksam ist, führt die Phasenanschnittseinheit, also zum Beispiel deren Thyristoren oder dergleichen, auch nur begrenzte Zeit Strom. Nur während dieser Zeit entsteht Wärme. Die entstehende Wärme ist im Vergleich zu der bei einem sogenannten Sanftstarter abzuführenden Wärme nur sehr gering. Kühlkörper zur Wärmeabfuhr oder dergleichen werden daher nicht benötigt. Dies gewährleistet eine Möglichkeit zur sehr kompakten Ausführung des hier vorgeschlagenen Motorstarters. Des Weiteren können für die Phasenanschnittseinheit Schaltelemente, also zum Beispiel Thyristoren, Triacs oder dergleichen, verwendet werden, die hinsichtlich ihrer Stromtragfähigkeit auf die geringe Betriebsdauer bei jedem Einschaltvorgang ausgelegt sind, und entsprechend können preiswertere und kleiner dimensionierte Schaltelemente verwendet werden als dies bei Sanftstartern erforderlich ist, die dort während des gesamten Einschaltvorgangs aktiv sind. Dies gewährleistet eine Möglichkeit zur preiswerten Ausführung des hier vorgeschlagenen Motorstarters.

Die Erfindung geht von der Erkenntnis aus, dass Motorstarter oder Verbraucherabzweige (Kombinationen von Schützen und Schutzgeräten), die keine Sanftstarter-Funktionalität/-Einrichtung beinhalten, nur durch entsprechende Überdimensionierung gegen ein unerwünschtes Ansprechen der jeweiligen Schutzfunktionen geschützt werden können. Im Falle eines Motorschutzschalters geschieht dies zum Beispiel durch entsprechend niedrige Ausnutzung des Motorschutzschalters. Der Kurzschluss-Auslösewert beträgt beispielsweise ca. das 13-fache des Gerätebemessungsstroms und der integrierte Überlastschutz kann in einem Bereich von ca. 65 % bis 100 % des Gerätebemessungsstroms eingestellt werden. Wird der Motorschutzschalter so ausgewählt, dass der Motorbemessungsstrom dem unteren Einstellwert des Leistungsschalters entspricht, ist der Anlauf des Motors mit einem fast 19-fachen Bemessungsstrom des Motors möglich, ohne dass die Schutzfunktion des Motorschutzschalters anspricht. Werden Motorstarter eingesetzt, die aufgrund ihrer Auslegung nur maximal den 8-fachen Motorbemessungsstroms als Maximalwert zulassen und mit einer entsprechenden Schutzfunktion ausgestattet sind, ist ebenfalls eine Überdimensionierung notwendig.

Mit der hier vorgeschlagenen Neuerung ist eine solche Überdimensionierung nicht mehr notwendig. Die Motorstarter können wie bisher gemäß der Produktnorm ausgelegt und geprüft werden. Die Realisierung einer nur kurzzeitigen Aktivierung des Phasenanschnitts ist relativ einfach möglich. Die dazu erforderlichen Komponenten wie Thyristoren oder Triacs mit der entsprechenden Ansteuerung sind in an sich bekannten Sanftstartern bereits vorhanden.

Mit der hier vorgeschlagenen Neuerung wird der Einsatz von Elektromotoren mit hohen Einschaltströmen problemloser. Dies vermeidet Fehlprojektierungen. Motorstarter entsprechend dem hier vorgeschlagenen Ansatz sind energieeffizienter, denn der Phasenanschnitt erfolgt erfindungsgemäß nur für eine Halbwelle der Netzfrequenz. Zudem ist ein Projektierungsaufwand geringer, da bei der Auslegung der Motorstarter der Einschaltstrom nicht mehr berücksichtigt werden muss.

Durch die erreichte Reduktion des Einschaltstroms (Einschaltrush) werden außerdem alle vom jeweiligen Elektromotor angetriebenen Lasten und Getriebe, Kupplungen sowie Riemenantriebe durch ein ebenfalls reduziertes Anzugsspitzenmoment geschont. Somit erhöht sich die Standzeit des gesamten Antriebsstrangs.

Die Dauer der Wirksamkeit der Phasenanschnittseinheit ist als die Dauer genau einer Halbwelle der Netzfrequenz des speisenden Netzes vorgegeben (die Dauer nur der ersten Halbwelle der Netzfrequenz nach dem Einschalten).

Vorteilhafte Ausgestaltungen der Erfindung sind Gegenstand der Unteransprüche. Dabei verwendete Rückbeziehungen innerhalb der Ansprüche weisen auf die weitere Ausbildung des Gegenstandes des in Bezug genommenen Anspruchs durch die Merkmale des jeweiligen abhängigen Anspruchs hin. Jede Bezugnahme in der Beschreibung auf Aspekte abhängiger Ansprüche ist demnach auch ohne speziellen Hinweis ausdrücklich als Beschreibung optionaler Merkmale zu lesen. Schließlich ist darauf hinzuweisen, dass das hier angegebene Verfahren auch entsprechend der abhängigen Vorrichtungsansprüche weitergebildet sein kann und umgekehrt, etwa indem der Motorstarter Mittel zur Ausführung einzelner oder mehrerer Schritte des Verfahrens umfasst oder das Verfahren Schritte umfasst, die mittels vom Motorstarter umfasster Vorrichtungen ausführbar sind.

Bei einer Ausführungsform des hier vorgeschlagenen Motorstarters oder eines Verfahrens zu dessen Betrieb umfasst die Steuerungseinheit einen Zähler, welcher mit einem die Wirksamkeitsdauer der Phasenanschnittseinheit kodierenden Initialisierungswert initialisierbar ist und beim Betrieb des Motorstarters mit einem solchen Initialisierungswert initialisiert wird. Die automatische Deaktivierung der Phasenanschnittseinheit nach dem Einschalten des Elektromotors und nach Ablauf der jeweils vorgegebenen oder vorgebbaren Wirksamkeitsdauer erfolgt, indem die Phasenanschnittseinheit mittels eines oder aufgrund eines bei Ablauf des Zählers generierten Deaktivierungssignals deaktiviert wird. Die Steuerungseinheit des Motorstarters, insbesondere deren Zähler, ist zu diesem Zweck dafür bestimmt und eingerichtet, bei Ablauf des Zählers ein Deaktivierungssignal zu generieren, und der Motorstarter ist insgesamt dafür bestimmt und eingerichtet, dass die Phasenanschnittseinheit mittels des Deaktivierungssignals oder aufgrund des Deaktivierungssignals deaktivierbar ist.

Die Dauer der Wirksamkeit der Phasenanschnittseinheit ist durch entsprechende Auswahl des Initialisierungswerts auf die Dauer genau einer Halbwelle der Netzfrequenz des speisenden Netzes (die Dauer nur der ersten Halbwelle der Netzfrequenz nach dem Einschalten) einstellbar. Für eine solche Einstellung der Dauer der Wirksamkeit der Phasenanschnittseinheit wird anhand der Netzfrequenz und der Zählertaktfrequenz ein der gewünschten Dauer entsprechender Initialisierungswert ermittelt und eingegeben.

Ein Zähler ist eine besonders einfache und effiziente Möglichkeit, den Ablauf der jeweils vorgegebenen oder vorgebbaren Wirksamkeitsdauer zu überwachen.

Bei einer weiteren Ausführungsform des hier vorgeschlagenen Motorstarters oder eines Verfahrens zu dessen Betrieb, die auch unabhängig von der automatischen Deaktivierung der Phasenanschnittseinheit nach Ablauf der Wirksamkeitsdauer in Betracht kommt und insoweit eine vorteilhafte Ausführungsform, aber genauso auch einen separaten Aspekt der hier vorgeschlagenen Neuerung darstellt, ist - kurz gefasst - vorgesehen, dass die Phasenanschnittseinheit einen Phasenanschnittswinkel dynamisch verändert und dabei einen günstigen oder optimalen Phasenanschnittswinkel gewissermaßen lernt. Ein Motorstarter mit dieser Funktion ist dafür bestimmt und eingerichtet, beim Einschalten des Elektromotors und während des Einschaltvorgangs einen Strommesswert aufzunehmen. Des Weiteren ist der Motorstarter dafür bestimmt und eingerichtet, einen beim Betrieb der Phasenanschnittseinheit verwendeten Phasenanschnittswinkel in Abhängigkeit von dem aufgenommenen Strommesswert und einem vorgegebenen oder vorgebbaren Referenzwert zu verändern. Bei einem korrespondierenden Verfahren zum Betrieb eines solchen Motorstarters wird ein beim Betrieb der Phasenanschnittseinheit verwendeter Phasenanschnittswinkel in Abhängigkeit von einem beim Einschalten und nach dem Einschalten des Motors aufgenommenen Strommesswert sowie einem vorgegebenen oder vorgebbaren Referenzwert verändert.

Bei einer speziellen Ausführungsform eines solchen Verfahrens zum Lernen eines günstigen oder optimalen Phasenanschnittswinkels oder eines zur Ausführung eines solchen Verfahrens bestimmten und eingerichteten Motorstarters wird ein Maximalwert des beim Einschalten und nach dem Einschalten des Motors aufgenommenen Strommesswerts ermittelt und bei einem den Referenzwert überschreitenden Maximalwert wird der Phasenanschnittswinkel vergrößert (erhöht). Die Dauer, während derer der Strommesswert erfasst wird und der Maximalwert des Stroms ermittelt wird, entspricht bevorzugt der für die Wirksamkeit der Phasenanschnittseinheit vorgegebenen oder vorgebbaren Wirksamkeitsdauer. Wenn das Lernen eines günstigen oder optimalen Phasenanschnittswinkels ohne eine zeitablaufabhängige Wirksamkeit der Phasenanschnittseinheit implementiert wird, wird - genauso wie ansonsten die Wirksamkeitsdauer der Phasenanschnittseinheit - eine Wirksamkeitsdauer der Erfassung des Strommesswerts vorgegeben und die Erfassung des Strommesswerts und die Ermittlung des Maximalwerts erfolgt nur während dieser Wirksamkeitsdauer.

Bei dieser Ausführungsform ist gewährleistet, dass die Anpassung des Phasenanschnittswinkels nicht von einem eventuell zu einem ungünstigen Zeitpunkt erfassten Strommesswert abhängt, sondern vielmehr von dem sich tatsächlich beim Einschalten und unmittelbar nach dem Einschalten einstellenden Maximalwert des zum Elektromotor fließenden Stroms abhängt. Die Anpassung des Phasenanschnittswinkels bewirkt dann genau die Reduktion dieses Maximalwerts.

Bei einer nochmals weiteren Ausführungsform eines Verfahrens zum Lernen eines günstigen oder optimalen Phasenanschnittswinkels ist vorgesehen, dass die Beeinflussung des Phasenanschnittswinkels mittels eines vom Motorstarter, insbesondere von dessen Steuerungseinheit, umfassten Reglers erfolgt. Bei einem solchen Motorstarter ist mittels des Reglers eine Differenz des anhand des Strommesswerts ermittelten Maximalwerts und des Referenzwerts als Regelabweichung sowie als Eingangssignal des Reglers verarbeitbar und mittels des Reglers ist anhand der Regelabweichung eine Stellgröße zur Beeinflussung des Phasenanschnittswinkels ausgebbar. Bei einem von einem solchen Motorstarter im Betrieb ausgeführten Verfahren wird mittels des Reglers eine Differenz des anhand des Strommesswerts ermittelten Maximalwerts und des Referenzwerts als Regelabweichung und als Eingangssignal des Reglers verarbeitet und mittels des Reglers wird anhand der Regelabweichung eine Stellgröße zur Beeinflussung des Phasenanschnittswinkels ausgegeben. Der Phasenanschnittswinkel wird dann entsprechend der Stellgröße verändert. Diese Ausführungsform erlaubt aufgrund des Reglers und der damit möglichen kontinuierlichen oder zumindest quasi-kontinuierlichen Veränderung des Phasenanschnittswinkels eine sehr genaue Einstellung des Phasenanschnittswinkels.

Eine Anwendung eines Motorstarters entsprechend dem hier vorgeschlagenen Ansatz oder ein Betrieb eines Motorstarters nach dem hier ebenfalls vorgeschlagenen Ansatz kommt zum Beispiel bei einem Förderband in Betracht, auf dem sich Ware befindet, welche nicht zu stark beschleunigt werden darf, also zum Beispiel nicht umfallen darf. Generell kommt der hier vorgeschlagene Ansatz (Motorstarter und Verfahren zu dessen Betrieb) bei allen Anwendungen in Betracht, die einen problemlosen Betrieb von Motoren der Energieeffizienzklasse IE3 oder IE4 verlangen.

Nachfolgend wird ein Ausführungsbeispiel der Erfindung näher erläutert. Einander entsprechende Gegenstände oder Elemente sind in allen Figuren mit den gleichen Bezugszeichen versehen.

Das Ausführungsbeispiel ist nicht als Einschränkung der Erfindung zu verstehen.

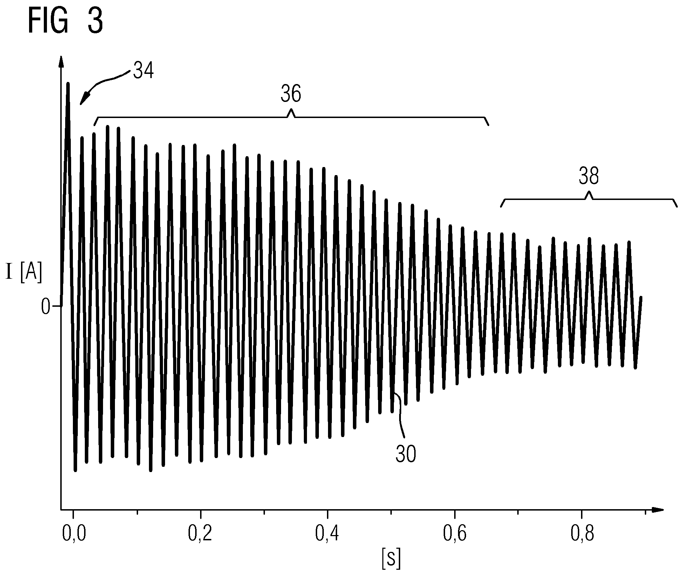

Es zeigen
FIG 1
   einen an ein elektrisches Netz angeschlossenen Elektromotor mit einem Motorstarter,

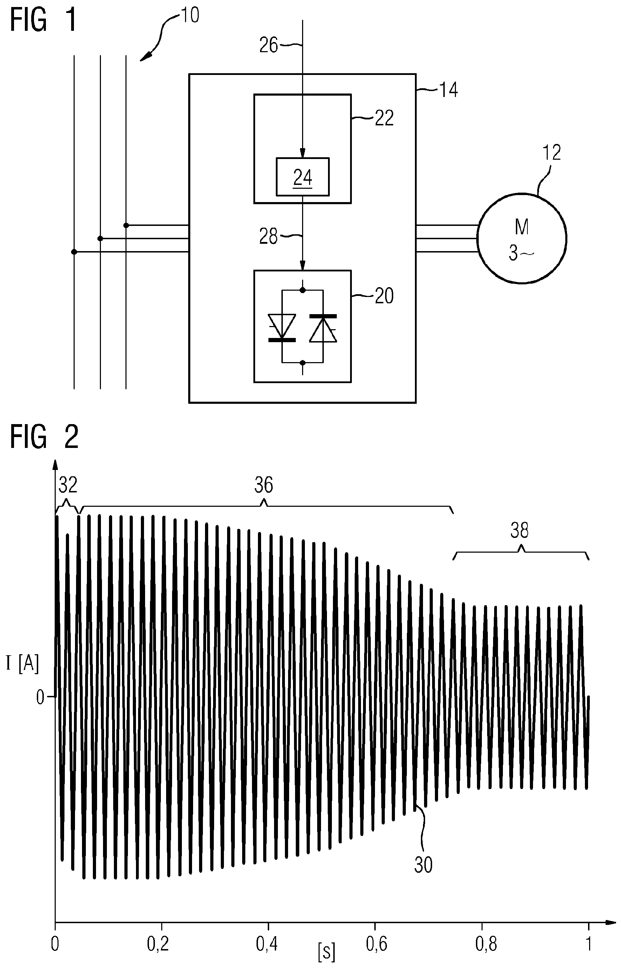

FIG 2 und
FIG 3
   einen Stromverlauf beim Einschalten eines Elektromotors, einmal mit und einmal ohne Sanftanlauf, wobei die in Fig. 3 gezeigte Situation nicht zur Erfindung gehört,
FIG 4
   eine optionale Ausführungsform eines Motorstarters und
FIG 5
   ein beispielhaftes Anwendungsszenario für einen mittels eines Motorstarters nach dem hier vorgeschlagenen Ansatz einschaltbaren oder im Betrieb eingeschalteten Elektromotor.

Die Darstellung in FIG 1 zeigt - schematisch stark vereinfacht - einen aus einem elektrischen Netz 10 (zwei- oder dreiphasig) gespeisten Elektromotor 12 einer niedrigen Leistungsklasse. Der Elektromotor 12 hat zum Beispiel eine Leistung von unter 5,5 kW.

Zum Sanftanlauf des Elektromotors 12 ist diesem ein zum Starten von Elektromotoren mit einer Leistung von ab ca. 5,5 kW grundsätzlich an sich bekannter und oftmals auch als Sanftanlaufgerät bezeichneter Motorstarter 14 vorgeschaltet. Der Motorstarter 14 umfasst - in ebenfalls grundsätzlich an sich bekannter Art und Weise - eine hier kurz als Phasenanschnittseinheit 20 bezeichnete Funktionseinheit, welche zum Phasenanschnitt zum Beispiel für zumindest eine Phase antiparallel geschaltete Thyristoren oder Triacs umfasst.

Die Phasenanschnittseinheit 20 wird mittels zumindest einer Steuerungseinheit 22 (Phasenanschnittssteuerungseinheit) angesteuert und/oder überwacht. Die Funktion der Phasenanschnittseinheit 20 umfasst optional eine grundsätzlich an sich bekannte Funktion zur Variation des Anschnittswinkels.

Einer der bei der hier vorgeschlagenen Neuerung im Vordergrund stehenden Aspekte ist eine zeitliche Begrenzung der Wirksamkeit des Phasenanschnitts mittels der Phasenanschnittseinheit 20. Dafür gibt die Steuerungseinheit 22 eine Dauer vor, während derer die Phasenanschnittseinheit 20 wirksam ist (Wirksamkeitsdauer 32; FIG 2) und einen Phasenanschnitt bewirkt. Die Steuerungseinheit 22 aktiviert die Phasenanschnittseinheit 20 beim Einschalten des Motors 12, überwacht die Dauer der Wirksamkeit der Phasenanschnittseinheit 20 und deaktiviert die Phasenanschnittseinheit 20 automatisch nach Ablauf der Wirksamkeitsdauer 32. Nach einer Deaktivierung der Phasenanschnittseinheit 20 erfolgt die Speisung des Elektromotors 12 mit der von dem Netz 10 bereitgestellten Spannung und dem von dem Netz 10 bereitgestellten Strom.

Die Steuerungseinheit 22 umfasst zur zeitablaufabhängigen Deaktivierung der Phasenanschnittseinheit 20 zum Beispiel einen als Watchdog fungierenden Zähler 24 oder dergleichen, der beim Einschalten des Motors 12 gestartet wird und nach Ablauf eine Deaktivierung der Phasenanschnittseinheit 20 bewirkt. Der Zähler 24 ist entweder ein aufwärts zählender Zähler 24 oder ein abwärts zählender Zähler 24. Bei einem aufwärts zählenden Zähler 24 wird der Zähler 24 beim Einschalten des Motors 12 gestartet und die Deaktivierung der Phasenanschnittseinheit 20 erfolgt, wenn ein vorgegebener oder vorgebbarer Zählerstand erreicht ist. Wenn der Zähler 24 ein abwärts zählender Zähler 24 ist, wird der Zähler 24 beim Einschalten des Motors mit einem vorgegebenen oder vorgebbaren Wert initialisiert und die Deaktivierung der Phasenanschnittseinheit 20 erfolgt, wenn der Zähler den Wert 0 erreicht.

Im Folgenden wird - ohne Verzicht auf eine weitergehende Allgemeingültigkeit - von einem abwärts zählenden Zähler 24 ausgegangen. Für einen aufwärts zählenden Zähler 24 gelten dieselben Verhältnisse entsprechend umgekehrt. Der abwärts zählende Zähler 24 wird beim Einschalten des Motors 12 mit dem vorgegebenen oder vorgebbaren Wert initialisiert (Initialisierungswert 26) und dieser Wert kodiert zusammen mit einer Frequenz (Zählertaktfrequenz), mit welcher der Zähler 24 den Zählerstand sukzessive dekrementiert, eine Dauer (also eine Zeitspanne) der Wirksamkeit der Phasenanschnittseinheit 20. Die Wirksamkeitsdauer 32 kann in grundsätzlich an sich bekannter Art und Weise über den Initialisierungswert 26 und/oder die Zählertaktfrequenz eingestellt werden. Die Dauer der Wirksamkeit der Phasenanschnittseinheit 20 ist damit optional im Wege einer Einstellung des Initialisierungswerts 26 und/oder der Zählertaktfrequenz parametrierbar.

In der Darstellung in FIG 1 ist schematisch vereinfacht eine Parametrierbarkeit des Zählers 24 mittels eines vorgebbaren Initialisierungswerts 26 gezeigt. Der Initialisierungswert 26 wird in an sich bekannter Art und Weise einer Speicherzelle eines nicht gezeigten Speichers, also zum Beispiel einer Speicherzelle der Steuerungseinheit 22, eingeprägt und beim Initialisieren des Zählers 24 in ebenfalls an sich bekannter Art und Weise aus dieser Speicherzelle geladen. Der Inhalt dieser Speicherzelle ist bevorzugt mit einem Standardwert vorbesetzt. Ohne eine Vorgabe eines Initialisierungswerts 26 fungiert dieser Standardwert als Initialisierungswert 26. Bei einer Parametrierung des Zählers 24 wird dieser Standardwert mit dem Initialisierungswert 26 überschrieben.

Der Initialisierungswert 26 ist zum Beispiel am Motorstarter 14 oder an der Steuerungseinheit 22 des Motorstarters 14 eingebbar. Bei einem mit anderen Geräten, zum Beispiel einer übergeordneten Einheit, kommunikativ verbindbaren Motorstarter 14 ist der Initialisierungswert 26 auch an einem anderen Gerät, zum Beispiel der übergeordneten Einheit, eingebbar und wird von dort leitungslos oder leitungsgebunden an den Motorstarter 14 oder an die Steuerungseinheit 22 übermittelt. Als kommunikative Verbindung kommt zum Beispiel ein Feldbus oder dergleichen in Betracht.

Die Dauer der Wirksamkeit der Phasenanschnittseinheit 20 ist durch entsprechende Auswahl des Initialisierungswerts 26 auf die Dauer genau einer Halbwelle der Netzfrequenz des speisenden Netzes 10 einstellbar (die Dauer nur der ersten Halbwelle der Netzfrequenz nach dem Einschalten). Für eine solche Einstellung der Dauer der Wirksamkeit der Phasenanschnittseinheit 20 wird anhand der Netzfrequenz und der Zählertaktfrequenz ein der gewünschten Dauer entsprechender Initialisierungswert 26 ermittelt und eingegeben.

Optional ist der Initialisierungswert 26 das Ergebnis einer (im Motorstarter 14, in der Steuerungseinheit 22 oder zum Beispiel in der übergeordneten Einheit erfolgenden) automatisch erfolgenden Zwischenverarbeitung. Dann ist die Parametrierung des Initialisierungswerts 26 mittelbar über Einheiten möglich, die für einen menschlichen Bediener besser verständlich sind. Optional ist zusätzlich oder alternativ eine Parametrierung des Initialisierungswerts 26 durch eine Vorgabe einer Dauer in Sekunden, Millisekunden oder dergleichen möglich. Die Umsetzung der Eingabe erfolgt im Wege einer rechnerischen Ermittlung des Initialisierungswerts 26 auf Basis der Eingabe sowie auf Basis der Netzfrequenz und der Zählertaktfrequenz. Die rechnerische Ermittlung des jeweiligen Initialisierungswerts 26 muss dann nicht mehr durch den Benutzer erfolgen und der Benutzer kann zur Vorgabe des Initialisierungswerts 26, also zur Spezifikation der Dauer der Wirksamkeit der Phasenanschnittseinheit 20, leicht verständliche Größen wie Zeiten oder eine Halbwelle der Netzfrequenz verwenden.

Abhängig von der jeweils eingestellten Dauer deaktiviert die Steuerungseinheit 22 die Phasenanschnittseinheit 20 automatisch nach Ablauf des Zählers 24, wenn dieser also ausgehend von dem jeweiligen Initialisierungwert 26 den Zählerstand 0 (Null) erreicht hat. Dies ist in der Darstellung in FIG 1 schematisch vereinfacht in Form eines von der Steuerungseinheit 22 bei Ablauf des Zählers 24 erzeugten und an die Phasenanschnittseinheit 20 ausgegebenen Deaktivierungssignals 28 gezeigt.

In der Darstellung in FIG 2 ist am Beispiel des Stromverlaufs einer Phase die Wirkung der zeitlich begrenzten Aktivierung der Phasenanschnittseinheit 20 gezeigt. Auf der Abszisse ist die Zeit in Sekunden ("[s]") abgetragen. Auf der Ordinate ist der Strom I in Ampere ("[A]") abgetragen. Die Aufzeichnung des Stromverlaufs 30 beginnt mit dem Einschalten des Motors 12, zum Beispiel eines Motors 12 wie in FIG 1 gezeigt. In der Darstellung in FIG 3 sind zum Vergleich dieselben Verhältnisse ohne Phasenanschnitt, also ohne Wirksamkeit der Phasenanschnittseinheit 20, gezeigt.

Unmittelbar nach dem Einschalten ergibt sich grundsätzlich der sogenannte Einschaltrush 34 (FIG 3), also eine Stromspitze. Aufgrund der Wirksamkeit der Phasenanschnittseinheit 20 unmittelbar nach dem Einschalten des Motors 12 ergibt sich nur eine sehr kurze Stromspitze. Die Dauer der Wirksamkeit der Phasenanschnittseinheit 20, die Wirksamkeitsdauer 32, entspricht bei der gezeigten, nicht zur Erfindung gehörenden Situation exemplarisch der Dauer einer Vollwelle der Netzfrequenz des speisenden Netzes 10.

Nach dem Einschalten des Motors 12 und den im Zusammenhang mit dem Einschalten resultierenden Effekten, welche den erhöhten Einschaltstrom hervorrufen, fällt der bezogene Strom in an sich bekannter Art und Weise während des Anlaufens des Motors 12 und einer resultierenden Anlaufphase 36 ab und schließlich stellt sich eine Speisung des Motors 12 mit dem Nennstrom während einer Betriebsphase 38 ein.

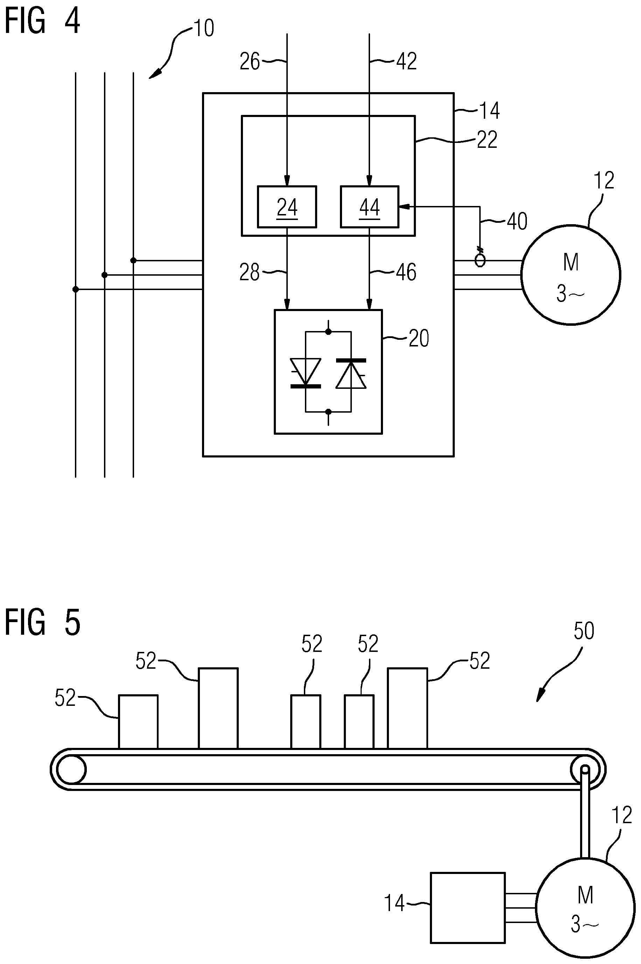

Die Darstellung in FIG 4 zeigt die Steuerungseinheit 22 mit weiteren grundsätzlich optionalen Einzelheiten. Danach verarbeitet die Steuerungseinheit 22 zumindest einen Strommesswert 40, nämlich einen in Bezug auf zumindest eine den Elektromotor 12 speisende Phase aufgenommenen Strommesswert 40. Beim Einschalten des Motors 12 und unmittelbar nach dem Einschalten des Motors 12, also zum Beispiel während der Dauer der Wirksamkeit der Phasenanschnittseinheit 20, wird anhand des Strommesswerts 40 ein Maximalwert ermittelt. Dieser wird mit einem vorgegebenen oder vorgebbaren Referenzwert 42 oder einem aus dem Referenzwert 42 resultierenden Schwellwert verglichen. Der Referenzwert 42 ergibt sich zum Beispiel anhand baureihentypischer Werte (Baureihe des jeweiligen Motors 12). Als Schwellwert wird zum Beispiel ein um 5 % verringerter Referenzwert verwendet. Wenn der beim Einschalten resultierende Maximalwert den Schwellwert oder den Referenzwert 42 überschreitet, ist die mittels der Phasenanschnittseinheit 20 erreichte Reduktion des Einschaltstroms zu gering. Dann wird der Winkel des Phasenanschnitts in Richtung auf eine Reduktion des Effektivwerts des an den Motor 12 abgegebenen Stroms verändert (Erhöhung des Phasenanschnittswinkels). Wenn der beim Einschalten resultierende Maximalwert den Referenzwert 42 nicht erreicht, wird der Winkel des Phasenanschnitts in Richtung auf eine Erhöhung des Effektivwerts des an den Motor 12 abgegebenen Stroms verändert (Verringerung des Phasenanschnittswinkels).

Eine solche automatische Anpassung des Phasenanschnittswinkels in Abhängigkeit von einem beim Einschalten des Motors 12 aufgenommenen Strommesswert 40 erfolgt zum Beispiel inkrementell, derart, dass bei jedem Einschalten des Motors 12 der Phasenanschnittswinkel um ein vorgegebenes oder vorgebbares Inkrement verändert wird, je nachdem, ob der ermittelte Maximalwert oberhalb oder unterhalb des Referenzwerts 42 liegt. Dann stellt sich nach mehreren Einschaltvorgängen schließlich ein günstiger Phasenanschnittswinkel ein.

Alternativ kann eine solche automatische Anpassung des Phasenanschnittswinkels in Abhängigkeit von einem beim Einschalten des Motors 12 aufgenommenen Strommesswert 40 auch mittels eines Reglers 44 realisiert sein, zum Beispiel mittels eines in Form eines Proportional-Reglers oder eines Proportional-Integral-Reglers oder dergleichen implementierten Reglers 44. Dann ist eine jeweilige Differenz aus dem beim Einschalten des Motors 12 ermittelten Maximalwert und dem Referenzwert 42 die vom Regler 44 verarbeitete Regelabweichung und der Regler 44 erzeugt als Stellgröße 46 für den Motorstarter 14 und den Motor 12 (Strecke) den Phasenanschnittswinkel oder ein Inkrement zur Veränderung des Phasenanschnittswinkels.

Eine solche Anpassung des Phasenanschnittswinkels erfolgt im Falle einer Erhöhung des Phasenanschnittswinkels zur Gewährleistung einer ausreichenden Begrenzung des Einschaltstroms. Im Falle einer Verringerung des Phasenanschnittswinkels erfolgt diese (bei einer Begrenzung des Einschaltstroms) zur Verringerung der thermischen Belastung durch den Phasenanschnitt.

Die von einem Maximalwert eines beim Einschalten des Elektromotors 12 gemessenen Strommesswerts 40 abhängige Anpassung des Phasenanschnittswinkels kann kurz als selbständiges Lernen eines optimalen oder günstigen Phasenanschnittswinkels (Lernen des Phasenanschnittswinkels) bezeichnet werden und ist ein separater Aspekt der hier vorgeschlagenen Neuerung. Ein solches Lernen des Phasenanschnittswinkels ist auch unabhängig von der zeitablaufabhängigen Deaktivierung der Phasenanschnittseinheit 20 implementierbar und eine von der zeitablaufabhängigen Deaktivierung der Phasenanschnittseinheit 20 unabhängige Implementierung des Lernens des Phasenanschnittswinkels ist als von der hier vorgelegten Beschreibung umfasst anzusehen und stets mitzulesen.

Anstelle eines Phasenanschnitts kann - sowohl bei der für eine begrenzte Dauer aktivierten Phasenanschnittseinheit 20 wie auch beim Lernen des Phasenanschnittswinkels - ein Phasenabschnitt erfolgen und insoweit ist bezüglich der hier vorgelegten Beschreibung bei jeder Erwähnung eines Phasenanschnitts ein Phasenabschnitt oder ein Phasenanschnitt und ein Phasenabschnitt gedanklich zu ergänzen und mitzulesen. Jedenfalls ist ein zusätzlicher oder alternativer Phasenabschnitt ein weiterer, optionaler Aspekt der hier vorgeschlagenen Neuerung.

Die Darstellung in FIG 5 zeigt abschließend - schematisch stark vereinfacht - einen Elektromotor 12, nämlich einen Elektromotor 12 mit einem Motorstarter 14 gemäß FIG 1 oder FIG 4. Der Elektromotor 12 treibt in grundsätzlich an sich bekannter Art und Weise eine Transporteinrichtung 50 an. Bei der Transporteinrichtung 50 handelt es sich zum Beispiel um ein Förderband oder dergleichen. Auf der Transporteinrichtung 50 bzw. auf dem Förderband befindet sich Ware 52, die nicht umfallen soll. Bei der Ware 52 handelt es sich zum Beispiel um aufrecht stehende Flaschen oder sonstige Behältnisse. Damit die Ware 52 beim Betrieb der Transporteinrichtung 50 nicht umfällt, darf die Ware 52 beim Starten der Transporteinrichtung 50 nur in begrenztem Umfang beschleunigt werden. Dies erfordert einen Sanftanlauf des Elektromotors 12. Der Sanftanlauf wird mittels eines Motorstarters 14 gemäß dem hier beschriebenen Ansatz sowie mittels eines Verfahrens zum Betrieb des Motorstarters 14 ebenfalls gemäß dem hier beschriebenen Ansatz gewährleistet, indem eine starke Beschleunigung der Transporteinrichtung 50 und der darauf befindlichen Ware 52 beim Anlaufen des Elektromotors 12 vermieden wird. Dies wird dadurch vermieden, dass beim Anlaufen des Elektromotors 12 zumindest kurzzeitig die Phasenanschnittseinheit 20 aktiv ist und diese ansonsten beim Einschalten des Elektromotors 12 resultierende Strom- und Spannungsspitzen vermeidet.

Obwohl die Erfindung im Detail durch das Ausführungsbeispiel näher illustriert und beschrieben wurde, so ist die Erfindung nicht durch das oder die offenbarten Beispiele eingeschränkt. Der Schutzumfang der Erfindung wird durch die Ansprüche definiert.

Einzelne im Vordergrund stehende Aspekte der hier eingereichten Beschreibung lassen sich damit kurz wie folgt zusammenfassen: Angegeben werden ein Motorstarter 14 und ein Verfahren zum Starten eines Elektromotors 12. Der Motorstarter 14 umfasst eine Phasenanschnittseinheit 20 und eine Steuerungseinheit 22. Mittels der Steuerungseinheit 22 ist die Phasenanschnittseinheit 20 nach Ablauf einer vorgegebenen oder vorgebbaren Wirksamkeitsdauer 32 der Phasenanschnittseinheit 20 deaktivierbar und wird im Betrieb nach Ablauf der Wirksamkeitsdauer 32 deaktiviert. Die Wirksamkeitsdauer 32 ist vergleichsweise kurz und die Wirksamkeitsdauer 32 entspricht der Dauer einer Halbwelle der jeweiligen Netzfrequenz.

## Patentansprüche

1. Motorstarter (14) zum Starten eines Elektromotors (12) und mit einer Phasenanschnittseinheit (20) und einer Steuerungseinheit (22),
wobei mittels der Steuerungseinheit (22) die Phasenanschnittseinheit (20) nach Ablauf einer vorgegebenen oder vorgebbaren Wirksamkeitsdauer (32) der Phasenanschnittseinheit (20) deaktivierbar ist,
**dadurch gekennzeichnet, dass**
die Wirksamkeitsdauer der Phasenanschnittseinheit (20) einer Halbwelle der Netzfrequenz entspricht.

2. Motorstarter (14) nach Anspruch 1,
wobei die Steuerungseinheit (22) einen Zähler (24) umfasst,
wobei der Zähler (24) mit einem die Wirksamkeitsdauer (32) der Phasenanschnittseinheit (20) kodierenden Initialisierungswert (26) initialisierbar ist und
wobei die Phasenanschnittseinheit (20) mittels eines oder aufgrund eines bei Ablauf des Zählers (24) generierbaren Deaktivierungssignals (28) deaktivierbar ist.

3. Motorstarter (14) nach Anspruch 1 oder 2,
wobei ein beim Betrieb der Phasenanschnittseinheit (20) verwendeter Phasenanschnittswinkel in Abhängigkeit von einem beim Einschalten des Motors (12) aufgenommenen Strommesswert (40) und einem vorgegebenen oder vorgebbaren Referenzwert (42) veränderbar ist.

4. Motorstarter (14) nach Anspruch 3,
wobei ein Maximalwert des beim Einschalten des Motors (12) aufgenommenen Strommesswerts (40) ermittelbar ist und
wobei bei einem den Referenzwert (42) überschreitenden Maximalwert der Phasenanschnittswinkel vergrößerbar ist.

5. Motorstarter (14) nach Anspruch 4
mit einem Regler (44),
wobei mittels des Reglers (44) eine Differenz des anhand des Strommesswerts (40) ermittelten Maximalwerts und des Referenzwerts (42) als Regelabweichung und als Eingangssignal des Reglers (44) verarbeitbar ist und
wobei mittels des Reglers (44) anhand der Regelabweichung eine Stellgröße (46) zur Beeinflussung des Phasenanschnittswinkels ausgebbar ist.

6. Verfahren zum Betrieb eines Motorstarters (14) mit einer Phasenanschnittseinheit (20) und einer Steuerungseinheit (22),
wobei die Steuerungseinheit (22) die Phasenanschnittseinheit (20) nach Ablauf einer vorgegebenen oder vorgebbaren Wirksamkeitsdauer (32) der Phasenanschnittseinheit (20) deaktiviert,
**dadurch gekennzeichnet, dass**
die Wirksamkeitsdauer der Phasenanschnittseinheit (20) einer Halbwelle der Netzfrequenz entspricht.

7. Verfahren nach Anspruch 6,
wobei der Zähler (24) mit einem die Wirksamkeitsdauer (32) der Phasenanschnittseinheit (20) kodierenden Initialisierungswert (26) initialisiert wird und
wobei die Phasenanschnittseinheit (20) mittels eines oder aufgrund eines bei Ablauf des Zählers (24) generierten Deaktivierungssignals (28) deaktiviert wird.

8. Verfahren nach einem der Ansprüche 6 oder 7,
wobei ein beim Betrieb der Phasenanschnittseinheit (20) verwendeter Phasenanschnittswinkel in Abhängigkeit von einem beim Einschalten des Motors (12) aufgenommenen Strommesswert (40) und einem vorgegebenen oder vorgebbaren Referenzwert (42) verändert wird.

9. Verfahren nach Anspruch 8,
wobei ein Maximalwert des beim Einschalten des Motors (12) aufgenommenen Strommesswerts (40) ermittelt wird und
wobei bei einem den Referenzwert (42) überschreitenden Maximalwert der Phasenanschnittswinkel vergrößert wird.

10. Verfahren nach einem der Ansprüche 6 bis 9,
wobei mittels eines Reglers (44) des Motorstarters (14) eine Differenz des anhand des Strommesswerts (40) ermittelten Maximalwerts und des Referenzwerts (42) als Regelabweichung und als Eingangssignal des Reglers (44) verarbeitet wird,
wobei mittels des Reglers (44) anhand der Regelabweichung eine Stellgröße (46) zur Beeinflussung des Phasenanschnittswinkels ausgegeben wird und
wobei der Phasenanschnittswinkel entsprechend der Stellgröße verändert wird.

11. System mit zumindest einer mittels eines Elektromotors (12) antreibbaren Transporteinrichtung (50),
wobei der Elektromotor (12) mittels eines Motorstarters (14) nach einem der Ansprüche 1 bis 5 einschaltbar ist und/oder mittels eines Verfahrens nach einem der Ansprüche 6 bis 10 eingeschaltet wird.

## Claims

1. Motor starter (14) for starting an electric motor (12) and having a phase gating unit (20) and a control unit (22),
wherein the phase gating unit (20) can be deactivated by means of the control unit (22) after a prespecified or prespecifiable activity period (32) of the phase gating unit (20) has elapsed,
**characterized in that**
the activity period of the phase gating unit (20) corresponds to a half-cycle of the supply system frequency.

2. Motor starter (14) according to Claim 1,
wherein the control unit (22) comprises a counter (24),
wherein the counter (24) can be initialized with an initialization value (26) which codes the activity period (32) of the phase gating unit (20), and
wherein the phase gating unit (20) can be deactivated by means of a or on account of a deactivation signal (28) which can be generated when the counter (24) has run down.

3. Motor starter (14) according to Claim 1 or 2,
wherein a phase gating angle which is used during operation of the phase gating unit (20) can be changed depending on a current measurement value (40), which is recorded when the motor (12) is switched on, and a prespecified or prespecifiable reference value (42).

4. Motor starter (14) according to Claim 3,
wherein a maximum value of the current measurement value (40), which is recorded when the motor (12) is switched on, can be ascertained, and
wherein the phase gating angle can be increased in size at a maximum value which exceeds the reference value (42).

5. Motor starter (14) according to Claim 4,
comprising a controller (44),
wherein a difference between the maximum value, which is ascertained on the basis of the current measurement value (40), and the reference value (42) can be processed as a control deviation and as an input signal of the controller (44) by means of the controller (44), and
wherein an actuating variable (46) for influencing the phase gating angle can be output by means of the controller (44) on the basis of the control deviation.

6. Method for operating a motor starter (14) comprising a phase gating unit (20) and a control unit (22),
wherein the control unit (22) deactivates the phase gating unit (20) after a prespecified or prespecifiable activity period (32) of the phase gating unit (20) has elapsed,
**characterized in that**
the activity period of the phase gating unit (20) corresponds to a half-cycle of the supply system frequency.

7. Method according to Claim 6,
wherein the counter (24) is initialized with an initialization value (26) which codes the activity period (32) of the phase gating unit (20), and
wherein the phase gating unit (20) is deactivated by means of a or on account of a deactivation signal (28) which is generated when the counter (24) has run down.

8. Method according to either of Claims 6 and 7,
wherein a phase gating angle which is used during operation of the phase gating unit (20) is changed depending on a current measurement value (40), which is recorded when the motor (12) is switched on, and a prespecified or prespecifiable reference value (42).

9. Method according to Claim 8,
wherein a maximum value of the current measurement value (40), which is recorded when the motor (12) is switched on, is ascertained, and
wherein the phase gating angle is increased in size at a maximum value which exceeds the reference value (42).

10. Method according to one of Claims 6 to 9,
wherein a difference between the maximum value, which is ascertained on the basis of the current measurement value (40), and the reference value (42) is processed as a control deviation and as an input signal of the controller (44) by means of a controller (44) of the motor starter (14),
wherein an actuating variable (46) for influencing the phase gating angle is output by means of the controller (44) on the basis of the control deviation, and
wherein the phase gating angle is changed in accordance with the actuating variable.

11. System comprising at least one transportation device (50) which can be driven by means of an electric motor (12),
wherein the electric motor (12) can be switched on by means of a motor starter (14) according to one of Claims 1 to 5 and/or is switched on by means of a method according to one of Claims 6 to 10.

## Revendications

1. Démarreur de moteur (14) destiné au démarrage d'un moteur électrique (12) et avec une unité de découpage de phases (20) et une unité de commande (22),
dans lequel au moyen de l'unité de commande (22) l'unité de découpage de phases (20) peut être désactivée après l'écoulement d'une durée de validité (32) prédéfinie ou apte à être prédéfinie de l'unité de découpage de phases (20),
**caractérisé en ce que** la durée de validité de l'unité de découpage de phases (20) correspond à une demi-onde de la fréquence de réseau.

2. Démarreur de moteur (14) selon la revendication 1,
dans lequel l'unité de commande (22) comprend un compteur (24),
dans lequel le compteur (24) peut être initialisé avec une valeur d'initialisation (26) codant la durée de validité (32) de l'unité de découpage de phases (20) et
dans lequel l'unité de découpage de phases (20) peut être désactivée au moyen ou en raison d'un signal de désactivation (28) pouvant être généré lors de l'écoulement du compteur (24).

3. Démarreur de moteur (14) selon la revendication 1 ou 2, dans lequel un angle de découpage de phases utilisé lors du fonctionnement de l'unité de découpage de phases (20) peut être modifié en fonction d'une valeur de mesure de courant (40) enregistrée lors de la mise en marche du moteur (12) et d'une valeur de référence (42) prédéfinie ou pouvant être prédéfinie.

4. Démarreur de moteur (14) selon la revendication 3,
dans lequel une valeur maximale de la valeur de mesure (40) enregistrée lors de la mise en marche du moteur (12) peut être déterminée et
dans lequel lorsqu'une valeur maximale dépasse la valeur de référence (42) l'angle de découpage de phases peut s'agrandir.

5. Démarreur de moteur (14) selon la revendication 4,
avec un régulateur (44),
dans lequel au moyen du régulateur (44) une différence de la valeur maximale déterminée à l'aide de la valeur de mesure de courant (40) et de la valeur de référence (42) peut être traitée en tant qu'écart de régulation et en tant que signal d'entrée du régulateur (44), et
dans lequel au moyen du régulateur (44) une grandeur de réglage (46) peut être émise à l'aide de l'écart de régulation pour l'influence de l'angle de découpage de phase.

6. Procédé destiné au fonctionnement d'un démarreur de moteur (14) avec une unité de découpage de phases (20) et une unité de commande (22),
dans lequel l'unité de commande (22) désactive l'unité de découpage de phases (20) après l'écoulement d'une durée de validité (32) prédéfinie ou pouvant être prédéfinie de l'unité de découpage de phases (20),
**caractérisé en ce que** la durée de validité de l'unité de découpage de phases (20) correspond à une demi-onde de la fréquence de réseau.

7. Procédé selon la revendication 6,
dans lequel l'unité de commande (22) comprend un compteur (24),
dans lequel le compteur (24) est initialisé avec une valeur d'initialisation (26) codant la durée de validité (32) de l'unité de découpage de phases (20) et
dans lequel l'unité de découpage de phases (20) est désactivée au moyen ou en raison d'un signal de désactivation (28) généré lors de l'écoulement du compteur (24).

8. Procédé selon l'une quelconque des revendications 6 ou 7, dans lequel un angle de découpage de phases utilisé lors du fonctionnement de l'unité de découpage de phases (20) est modifié en fonction d'une valeur de mesure de courant (40) enregistrée lors de la mise en marche du moteur (12) et d'une valeur de référence (42) prédéfinie ou pouvant être prédéfinie.

9. Procédé selon la revendication 8,
dans lequel une valeur maximale de la valeur de mesure de courant (40) enregistrée lors de la mise en marche du moteur (12) est déterminée et
dans lequel lorsqu'une valeur maximale dépasse la valeur de référence (42) l'angle de découpage de phases est agrandi.

10. Procédé selon l'une quelconque des revendications 6 à 9,
dans lequel au moyen d'un régulateur (44) du démarreur de moteur (14) une différence de la valeur maximale déterminée à l'aide de la valeur de mesure de courant (40) et de la valeur de référence (42) est traitée en tant qu'écart de régulation et en tant que signal d'entrée du régulateur (44),
dans lequel au moyen du régulateur (44) une grandeur de réglage (46) est émise à l'aide de l'écart de régulation pour l'influence de l'angle de découpage de phases et
dans lequel l'angle de découpage de phases est modifié en fonction de la grandeur de réglage.

11. Système avec au moins un dispositif de transport (50) pouvant être entraîné au moyen d'un moteur électrique (12), dans lequel le moteur électrique (12) peut être mis en marche au moyen d'un démarreur de moteur (14) selon l'une quelconque des revendications 1 à 5 et/ou est mis en marche au moyen d'un procédé selon l'une quelconque des revendications 6 à 10.
